# EUROPEAN PATENT APPLICATION

(11) **EP 2 957 166 A1**
(43) Date of publication of application: **23.12.2015**
(21) Application number: 13875147.4
(22) Date of filing: 11.12.2013
(51) Int. Cl.: A01G 7/00, H01L 33/50

(54) **LED LIGHT SOURCE FOR PLANT CULTIVATION**

(30) Priority: 15.02.2013 JP 2013028314
(71) Applicant: Sharp Kabushiki Kaisha, Osaka-shi, Osaka 545-8522 (JP)
(72) Inventor: KAWAGUCHI, Yoshihiro, Osaka-shi, Osaka 545-8522 (JP); ITAKURA, Yoshiaki, Osaka-shi, Osaka 545-8522 (JP)
(74) Representative: Treeby, Philip David William
(86) International application number: PCT/JP2013/083213
(87) International publication number: WO 2014/125714

(57) **Abstract**

A plant cultivation LED light source (1A) of the present invention includes: a substrate (2A); at least one blue LED chip (11), provided on the substrate (2A), for emitting blue light; a red phosphor mixed resin (12) which is provided so as to cover the blue LED chip (11) and contains red phosphors (12a) being dispersed or settled down therein, each of the red phosphors (12a) emitting red light in response to excitation light emitted from the blue LED chip (11); and a silicone resin (13) which is transparent and is provided so as to cover the red phosphor mixed resin (12).

## Description

### Technical Field

The present invention relates to a plant cultivation LED light source for emitting light to be absorbed by a plant which requires light in order to carry out photosynthesis for growth.

### Background Art

Conventionally known light-emitting devices provided with an LED (Light Emitting Diode) include, for example, light-emitting devices disclosed in Patent Literatures 1 through 5.

Patent Literature 1 discloses a light-emitting device provided with LEDs, the light-emitting device including (i) a blue light-emitting element for emitting blue light and (ii) a phosphor layer (a) being coated on the blue light-emitting element and (b) including phosphors which emit monochromatic light other than the blue light in response to excitement by the blue light. The light-emitting device has such an optical spectrum that a light emission intensity at a peak wavelength of the blue light is not more than 35% of a light emission intensity of a peak wavelength of the phosphors.

Patent Literature 2 discloses an LED device configured such that (i) at least one of a plurality of LEDs is provided so as to be adjacent to another one of the plurality of LEDs and (ii) at least one of the plurality of LEDs generates radiation having a full width at half maximum greater than 50 nm. The full width at half maximum refers to a wavelength range in which an LED emits light at 50% of a maximum radiation power.

Patent Literature 3 discloses a light-emitting device including (i) a first semiconductor light-emitting element for emitting light having a main light emission wavelength which is short, (ii) a second semiconductor light-emitting element for emitting light having a main light emission wavelength which is longer than that of light emitted from the first semiconductor light-emitting element, and (iii) a color conversion member including phosphors each of which (a) absorbs light emitted from the first semiconductor light-emitting element and light emitted from the second semiconductor light-emitting element and (b) emits visible light having a wavelength longer than those of light emitted from the first and second semiconductor light-emitting elements.

Patent Literature 4 discloses an LED device 100 including, as illustrated in Fig. 13, a wiring substrate 101, at least one LED element 102 which is provided on the wiring substrate 101, and a resin material 110 for sealing the LED element 102. The resin material 110 includes (i) a first resin material 111 which is provided on the wiring substrate 101 so as to surround the LED element 102 without being in contact with the LED element 102 and (ii) a second resin material 112 which is provided on a region of the wiring substrate 101 so as to coat the LED element 102, the region being surrounded by the first resin material 111. Phosphors 103 are mixed in the second resin material 112.

Patent Literature 5 discloses a heat sink 200 including, as illustrated in (a) and (b) of Fig. 14, an LED module 201 provided on a substrate 202. The substrate 202 is fixed, via a thermal conductive resin 211, to a heat sink body 210 including a plurality of fins 212 that are made of finely-thermally conductive metal or a carbon material and are arranged in a row. Patent Literature 5 discloses that this makes it possible to provide the heat sink 200 which is to be used for cooling an LED module having high luminance of not less than 1W.

### Citation List

### Patent Literatures

Patent Literature 1
   Japanese Patent Application Publication, Tokukai, No. 2008-235680 A (Publication Date: October 2, 2008)
Patent Literature 2
   Japanese Patent Application Publication, Tokukai, No. 2006-173622 A (Publication Date: June 29, 2006)
Patent Literature 3
   Japanese Patent Application Publication, Tokukai, No. 2011-101040 A (Publication Date: May 19, 2011)
Patent Literature 4
   Japanese Patent Application Publication, Tokukai, No. 2006-324589 A (Publication Date: November 30, 2006)
Patent Literature 5
   Japanese Patent Application Publication, Tokukai, No. 2011-061157 A (Publication Date: March 24, 2011)

### Summary of Invention

### Technical Problem

However, none of the conventional light-emitting devices described in Patent Literatures 1 through 5 is disclosed or suggested as a light-emitting device for plant cultivation.

For example, according to the light-emitting device provided with LEDs that is disclosed in Patent Literature 1, the LEDs are provided such that a light emission intensity of blue light is not more than 35% of that of red light. Red LEDs and blue LEDs are typically used in combination. However, the red LEDs can be solely used depending on a plant for which the light-emitting device is used.

However, the following problems (1) through (3) arise in both cases where the red LEDs and the blue LEDs are used in combination and where the red LEDs are solely used.

(1) It is difficult to dispose red LED chips and blue LED chips in order to use the red and blue LED chips in combination. Specifically, this requires a very large area to provide the red and blue LED chips. Further, it is difficult to regularly arrange the red LED chips and the blue LED chips in corners.

(2) For the above use, it is necessary to adjust a light amount ratio of blue region light to red region light. In a case where this adjustment is carried out by changing the number of blue LED chips or the number of red LED chips, the light amount ratio changes after long-term driving due to a difference in deterioration characteristics between the LED chips.

In order to provide the LEDs such that an amount of blue LED light is not more than 35% of an amount of red LED light,
Measure (A): Causing the red LED chips to emit light having high luminance (i.e., increasing an electric current to drive the red LED chips);
Measure (B): Increasing the number of LED chips to be mounted; and/or
Measure (C): Increasing the number of red LED chips

### should be carried out, for example.

However, in a case where the measure (A) is taken, the difference in deterioration characteristics between the blue LED chips and the red LED chips is increased, and thus the change of the light amount ratio after the long-term driving is increased. Further, in order to adjust the amount of light electrically, a member such as an electric drive circuit needs to be provided, and this causes the light-emitting device to have a complicated configuration. In a case where the measure (B) is taken, the red LED chips are increased in size. This causes a problem such as difficult control of wide angle directivity. In a case where the measure (C) is taken, the number of blue LED chips is small. Accordingly, even by regularly arranging the blue LED chips or by employing the blue LED chips having wide angle directivity, color mixture of red light and blue light is insufficient and thus color unevenness is likely to occur.

(3) It is difficult to mix colors by use of the blue LED chips and the red LED chips, and thus it is difficult to obtain a mixed color necessary for cultivation of a plant. Specifically, in a case where a plurality of independent blue LED chips and a plurality of independent red LED chips are provided, it is extremely difficult to obtain a mixed color which satisfies a given light amount ratio and which is uniform and not spatially uneven.

The present invention has been made in view of the conventional problems. An object of the present invention is to provide a plant cultivation LED light source which has a simple configuration and enables (i) easy adjustment of a light amount ratio of blue region light to red region light and (ii) increase in light extraction efficiency, without increasing an area for mounting.

### Solution to Problem

In order to attain the object, a plant cultivation LED light source of an aspect of the present invention includes: a substrate; at least one blue LED chip, provided on the substrate, for emitting blue light; a red phosphor mixed resin which is provided so as to cover the blue LED chip and contains red phosphors being dispersed or settled down therein, each of the red phosphors emitting red light in response to excitation light emitted from the blue LED chip; and a silicone resin which is transparent and is provided so as to cover the red phosphor mixed resin.

### Advantageous Effects of Invention

According to the aspect of the present invention, it is possible to provide a plant cultivation LED light source which has a simple configuration and enables (i) easy adjustment of a light amount ratio of blue region light to red region light and (ii) increase in light extraction efficiency, without increasing an area for mounting.

### Brief Description of Drawings

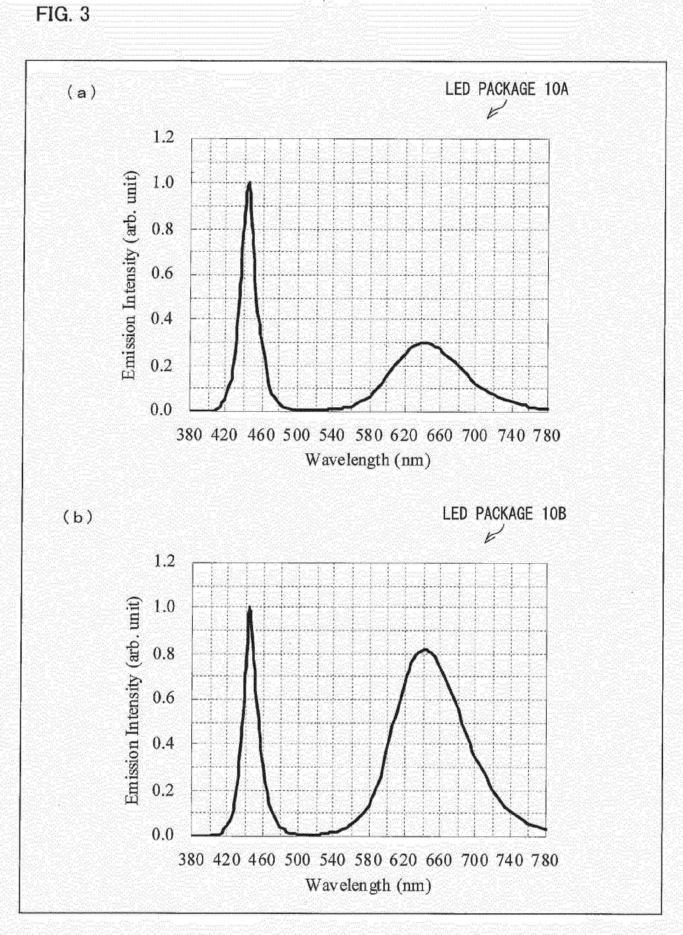

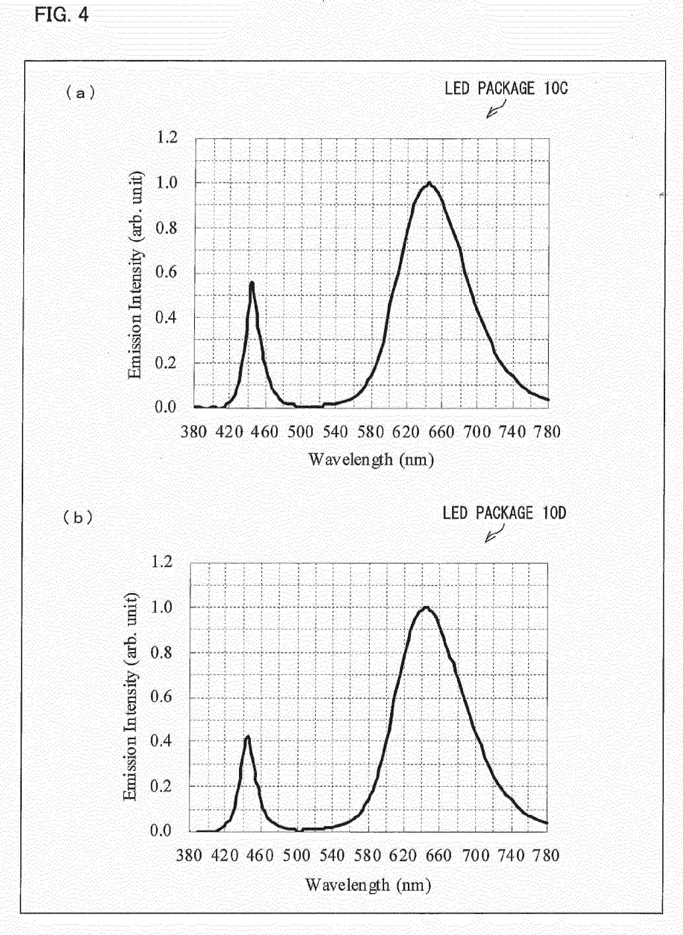

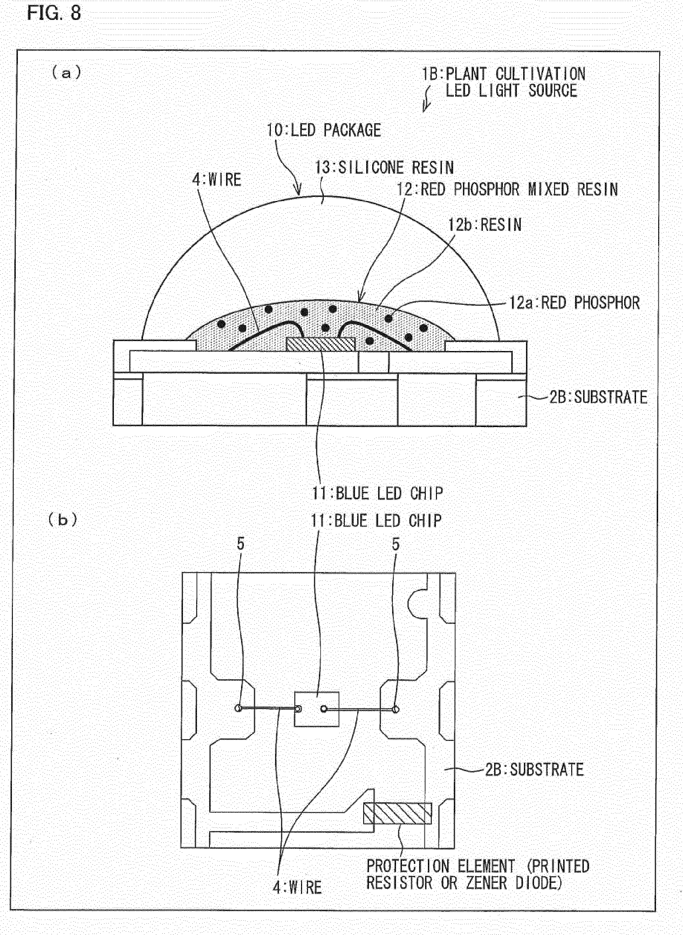

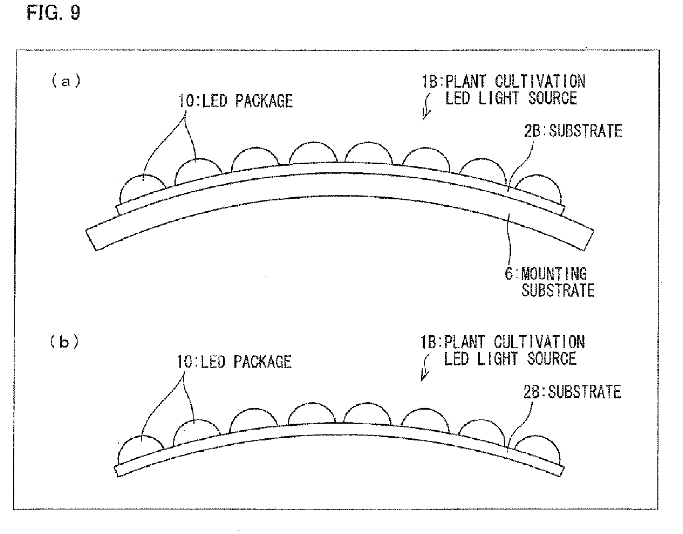

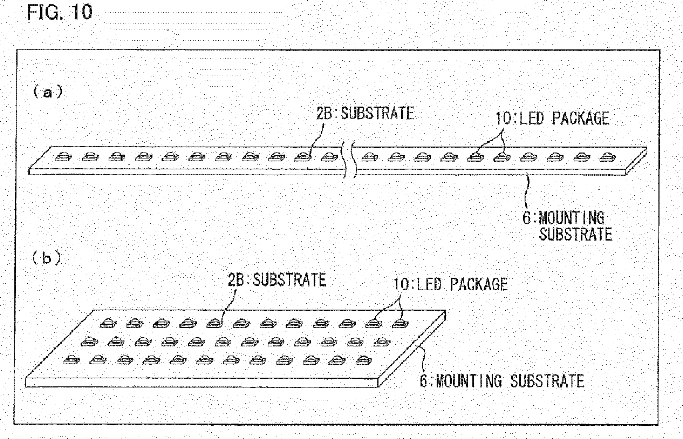

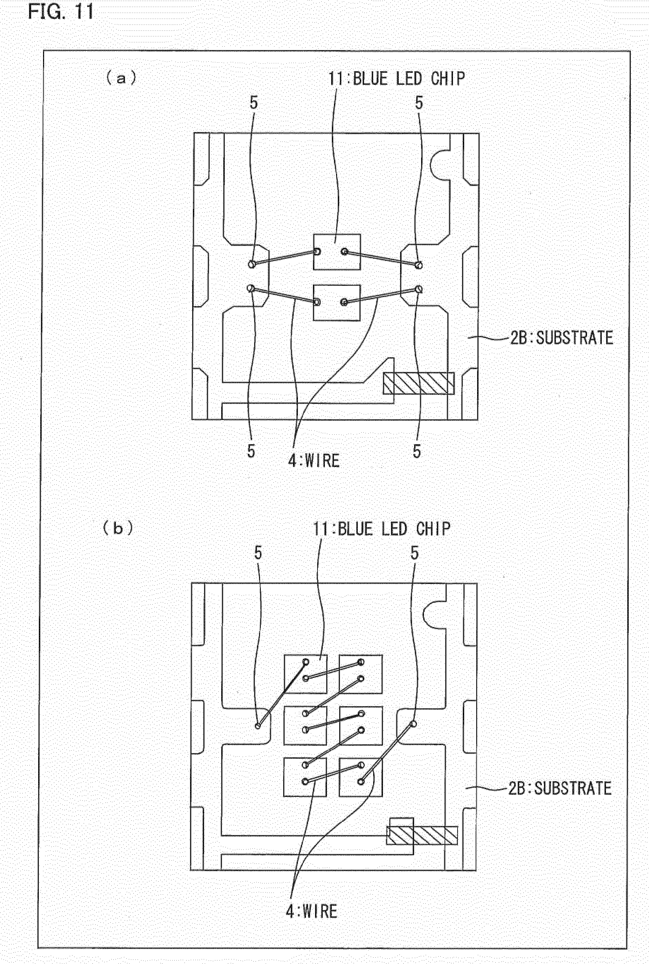

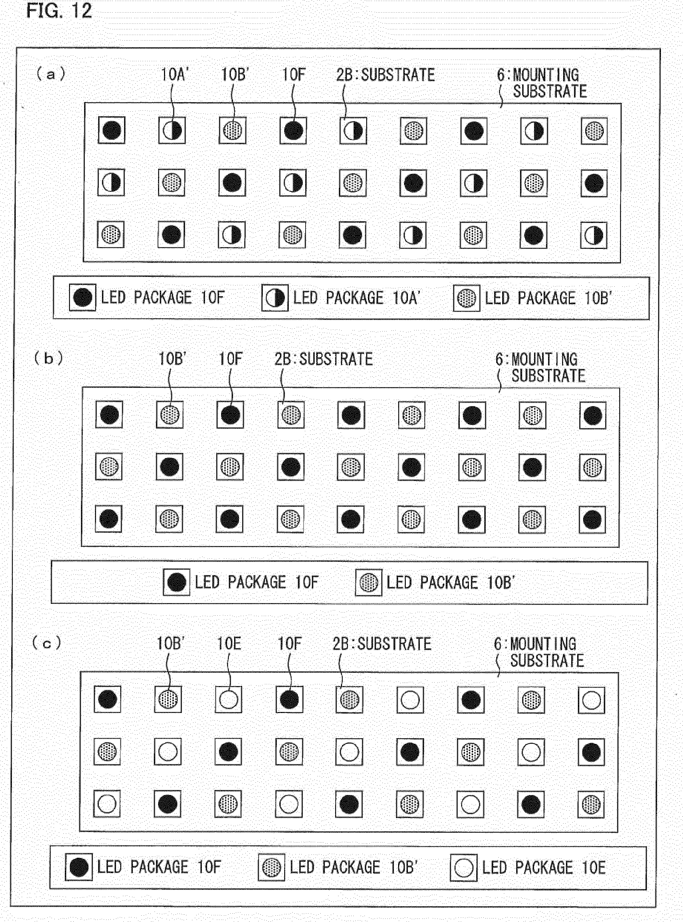

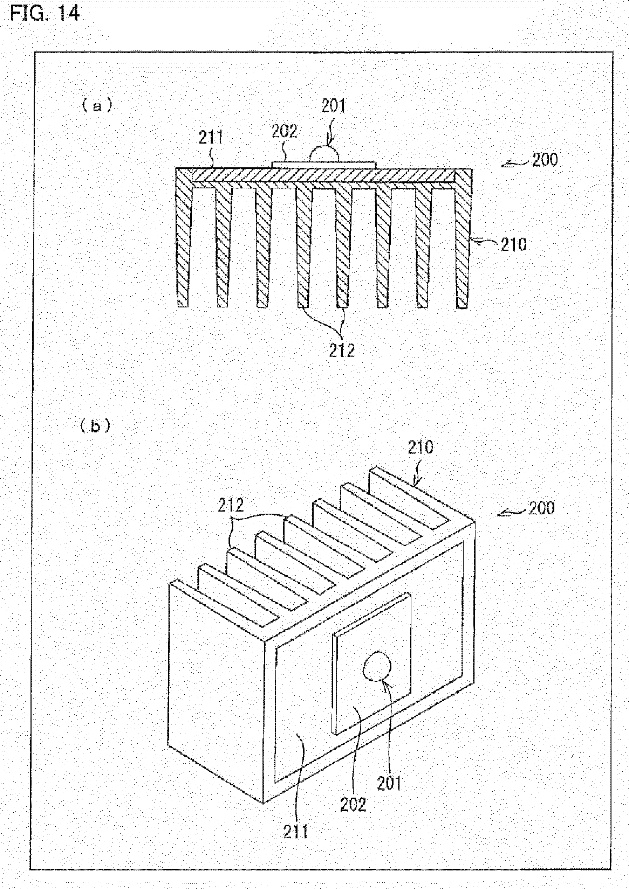

Fig. 1 is a cross sectional view illustrating a configuration of a plant cultivation LED light source of Embodiment 1 of the present invention.
Fig. 2 is a side view illustrating a configuration of a plant cultivation LED light source including a plurality of LED packages on a mounting substrate.
   (a) of Fig. 3 is a graph showing a light emission spectrum of the plant cultivation LED light source including a red phosphor mixed resin in which a resin and red phosphors are mixed in a ratio of 1:0.05. (b) of Fig. 3 is a graph showing a light emission spectrum of the plant cultivation LED light source including a red phosphor mixed resin in which a resin and red phosphors are mixed in a ratio of 1:0.10.
   (a) of Fig. 4 is a graph showing a light emission spectrum of the plant cultivation LED light source including a red phosphor mixed resin in which a resin and red phosphors are mixed in a ratio of 1:0.15. (b) of Fig. 4 is a graph showing a light emission spectrum of the plant cultivation LED light source including a red phosphor mixed resin in which a resin and red phosphors are mixed in a ratio of 1:0.20.

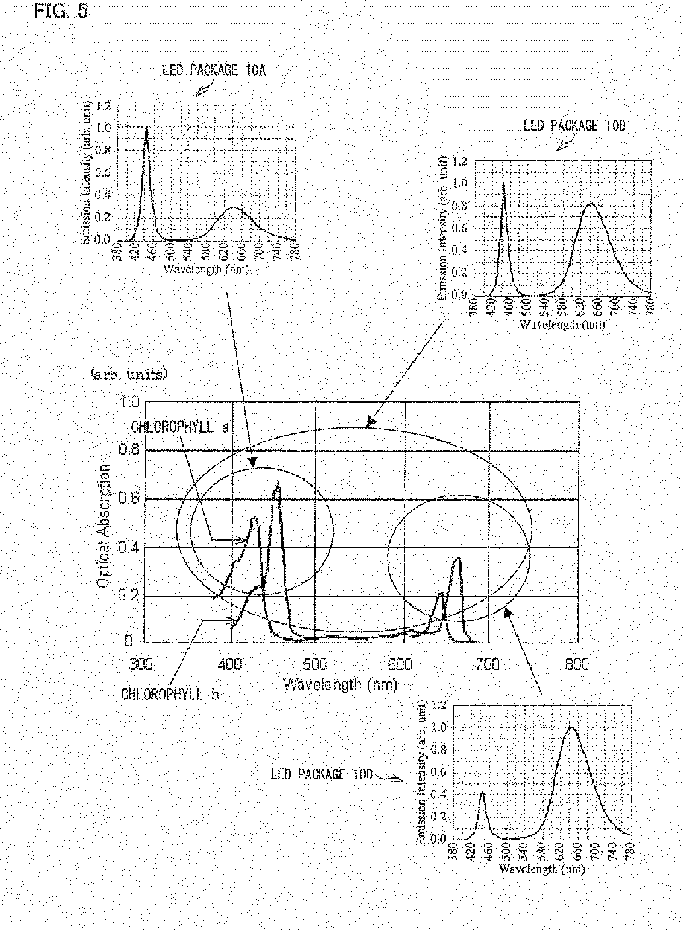

Fig. 5 is a view illustrating an absorption spectrum of chlorophyll and application examples of the LED packages of the plant cultivation LED light source.

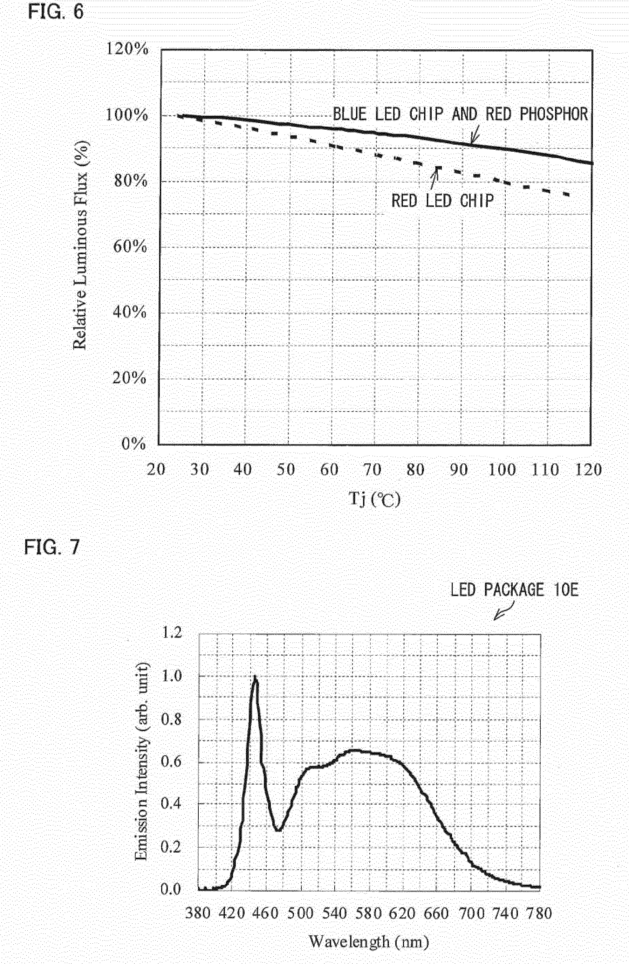

Fig. 6 is a graph showing a temperature characteristic of an LED package of the plant cultivation LED light source, in terms of comparison with an LED package of a conventional plant cultivation LED light source.
Fig. 7 is a graph showing a light emission spectrum of an LED package for illumination of the plant cultivation LED light source.
   (a) of Fig. 8 is a cross sectional view illustrating a configuration of a plant cultivation LED light source of Embodiment 2 of the present invention. (b) of Fig. 8 is a plan view illustrating a configuration of the plant cultivation LED light source, in which plan view no red phosphor mixed resin or silicone resin is illustrated.
   (a) of Fig. 9 is a side view illustrating a configuration of a plant cultivation LED light source including (i) a mounting substrate made of a film-like base material, (ii) a substrate provided on the mounting substrate and made of a film-like base material, and (iii) a plurality of LED packages provided on the substrate, the mounting substrate being warped. (b) of Fig. 9 is a side view illustrating a configuration of a plant cultivation LED light source including (i) a substrate made of a film-like base material and (ii) a plurality of LED packages provided on the substrate, the substrate being warped.
   (a) of Fig. 10 is a perspective view illustrating a configuration of a plant cultivation LED light source including (i) a mounting substrate having a strip shape and (ii) a plurality of LED packages arranged on the mounting substrate. (b) of Fig. 10 is a perspective view illustrating a configuration of a plant cultivation LED light source including (i) a mounting substrate having a rectangular shape and (ii) a plurality of LED packages arranged on the mounting substrate.
   (a) of Fig. 11 is a plan view illustrating a configuration of a plant cultivation LED light source including (i) a substrate and (ii) a plurality of blue LED chips electrically connected in parallel on the substrate. (b) of Fig. 11 is a plan view illustrating a configuration of a plant cultivation LED light source including (i) a substrate and (ii) a plurality of blue LED chips electrically connected in series on the substrate.
   Each of (a) through (c) of Fig. 12 is a plan view illustrating an example configuration of the plant cultivation LED light source in which various different types of LED packages being different in a light amount ratio of (i) blue region emission light to (ii) red region emission light are arranged in combination on a substrate.

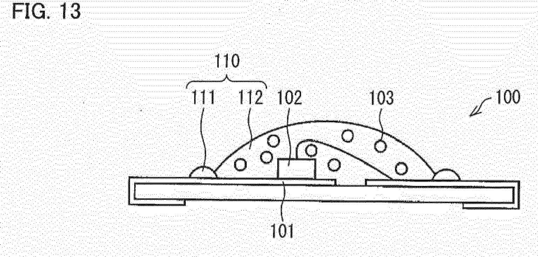

Fig. 13 is a cross sectional view illustrating a configuration of a conventional light emitting device including an LED.
   (a) of Fig. 14 is a cross sectional view illustrating a configuration of another conventional light emitting device including an LED. (b) of Fig. 14 is a perspective view illustrating a configuration of the light emitting device.

### Description of Embodiments

### [Embodiment 1]

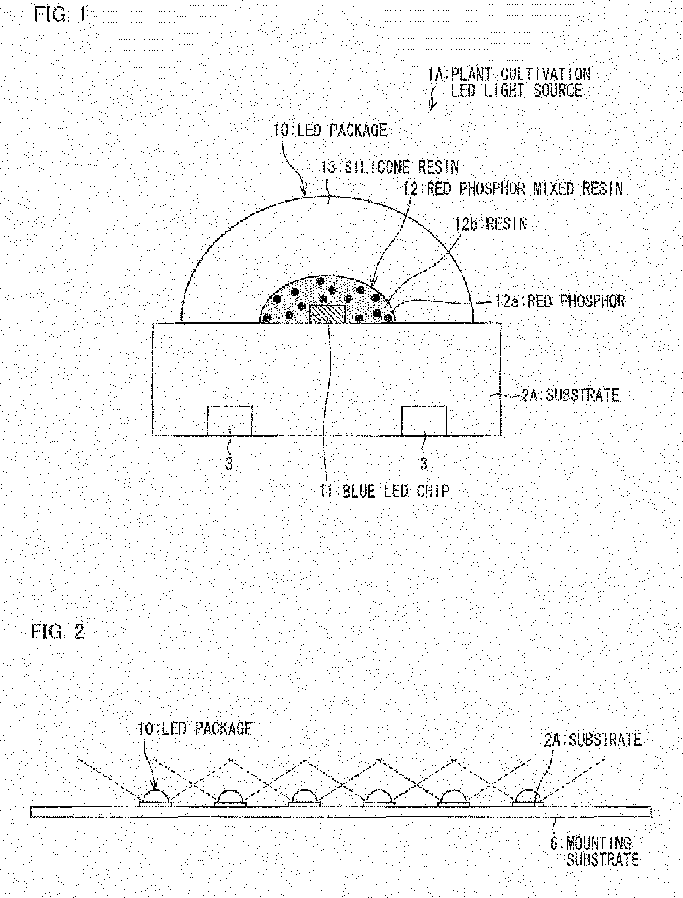

An embodiment of the present invention is described below with reference to Figs. 1 through 7.

### (Configuration of Plant Cultivation LED Light Source)

The following describes a plant cultivation LED light source of Embodiment 1 with reference to Fig. 1. Fig. 1 is a cross sectional view illustrating a configuration of a plant cultivation LED light source of Embodiment 1.

As illustrated in Fig. 1, a plant cultivation LED light source 1A of Embodiment 1 includes at least one blue LED (Light Emitting Diode) chip 11 provided on a substrate 2A. A red phosphor mixed resin 12, in which red phosphors 12a are dispersed or settled down, is provided around the blue LED chip 11 so as to cover the blue LED chip 11. Further, a transparent silicone resin 13 is provided so as to cover the red phosphor mixed resin 12. Thus, the plant cultivation LED light source 1A of Embodiment 1 includes, on the substrate 2A, an LED package 10 in which the blue LED chip 11 is double-sealed with the red phosphor mixed resin 12 and the silicone resin 13. Fig. 1 illustrates the plant cultivation LED light source 1A in which the single LED package 10 is provided on the substrate 2A. Note, however, that the plant cultivation LED light source 1A is not necessarily limited to such a configuration, but can be configured such that a plurality of LED packages 10 are provided on the substrate 2A. Such a plant cultivation LED light source in which the plurality of LED packages 10 are provided on the substrate 2A will be described in detail in Embodiment 2.

The substrate 2A is made of, for example, a ceramic base material. This makes it possible to provide the substrate 2A having a high heat insulation performance.

The substrate 2A includes electrodes 3 on its back surface. The blue LED chip 11 provided on the substrate 2A is therefore connected to the electrodes 3 via respective through-electrodes (not illustrated) so that an electric power is supplied to the blue LED chip 11. Note, however, that the blue LED chip 11 is not necessarily connected to the electrodes 3 via the respective through-electrode. Alternatively, for example, the electrodes 3 can be provided on a side surface of the substrate 2A.

According to the plant cultivation LED light source 1A of Embodiment 1, as described above, the red phosphor mixed resin 12 in which the red phosphors 12a are dispersed or settled down is provided so as to cover the blue LED chip 11. The red phosphor mixed resin 12 includes a resin 12b in which the red phosphors 12a are dispersed or settled down, and the resin 12b is made of a transparent silicone resin.

The blue LED chip 11 generates blue light having a light emission peak at a wavelength in a range of 400 nm to 480 nm, which corresponds to a blue region light-absorption peak of chlorophyll. Meanwhile, the red phosphors 12a each absorb blue light emitted from the blue LED chip 11 and then emit red light having a light emission peak at a wavelength in a range of 620 nm to 700 nm, which corresponds to a red region light-absorption peak of chlorophyll.

Note that the blue LED chip 11 can be configured to emit light in a blue-ultraviolet region including an ultraviolet, in addition to light having a light emission peak at a wavelength in a range of 400 nm to 480 nm, which corresponds to the blue region light-absorption peak of chlorophyll.

According to the plant cultivation LED light source 1A of Embodiment 1, the transparent silicone resin 13 covering the red phosphor mixed resin 12 has a dome shape. Accordingly, the silicone resin 13 acts as a lens. Thus, refraction given by the silicone resin 13, which acts as a lens, makes it possible to converge light in a given direction. As a result, light emitted from the blue LED chip 11 and the red phosphor mixed resin 12 can reach a more distant position. This makes it possible to increase an amount of light to be emitted to a plant in a distant position, thereby increasing light extraction efficiency. Thus, it is possible to provide the plant cultivation LED light source 1A with which light extraction efficiency is increased.

According to the plant cultivation LED light source 1A of Embodiment 1, the LED package 10 includes the blue LED chip 11 that is double-sealed with the red phosphor mixed resin 12 and the silicone resin 13, and the red phosphor mixed resin 12 and the silicone resin 13 each have a dome shape as described above. This makes it possible to uniformly and radially emit light in a wide range. That is, in a case where the plant cultivation LED light source 1A has a side wall, no light is emitted from a side surface of the blue LED chip 11. However, in the case where the red phosphor mixed resin 12 and the silicone resin 13 each have a dome shape, it is possible to emit light even from a side surface of the LED package 10. As a result, in a case where a plurality of LED packages 10 are arranged on a mounting substrate 6 as illustrated in Fig. 2, an entire upper surface of the mounting substrate 6 functions as a planar light source for emitting uniform light.

### (Adjustment of Light Amount Ratio of Blue Region Light to Red Region Light)

With reference to (a) and (b) of Fig. 3 and (a) and (b) of Fig. 4, the following describes how to adjust a light amount ratio of blue region light to red region light which are emitted from the LED package 10 of the plant cultivation LED light source 1A of Embodiment 1. (a) of Fig. 3 is a graph showing a light emission spectrum of a plant cultivation LED light source including a red phosphor mixed resin in which a resin and red phosphors are mixed in a ratio of 1:0.05. (b) of Fig. 3 is a graph showing a light emission spectrum of a plant cultivation LED light source including a red phosphor mixed resin in which a resin and red phosphors are mixed in a ratio of 1:0.10. (a) of Fig. 4 is a graph showing a light emission spectrum of the plant cultivation LED light source including a red phosphor mixed resin in which a resin and red phosphors are mixed in a ratio of 1:0.15. (b) of Fig. 4 is a graph showing a light emission spectrum of the plant cultivation LED light source including a red phosphor mixed resin in which a resin and red phosphors are mixed in a ratio of 1:0.20.

According to the plant cultivation LED light source 1A of Embodiment 1, the red phosphor mixed resin 12 of the LED package 10 includes the resin 12b which is made of a silicone resin and in which the red phosphors 12a are dispersed or settled down. Thus, it is possible to emit light having a different wavelength by changing a ratio of the red phosphors 12a to the resin 12b in the LED package 10.

For example, in a case where CaAlSiN₃ :Eu is used as the red phosphors 12a and the blue LED chip 11 emits light having a light emission peak at a wavelength in a range of 400 nm to 480 nm as described above, the plant cultivation LED light source 1A emits blue light having a wavelength of 400 nm to 480 nm and red light having a wavelength of 620 nm to 700 nm. Note that CaAlSiN₃ :Eu is a nitride red phosphor which contains divalent europium (Eu) as an activator, and is one of phosphors having a stable temperature characteristic and high luminous efficiency.

Specifically, as illustrated in (a) of Fig. 3, an LED package 10A in which the resin 12b and the red phosphors 12a are mixed in a ratio of 1:0.05 provides a spectrum in which (i) a peak wavelength having an emission intensity of 1.0 is observed at a wavelength of 440 nm and (ii) a peak wavelength having an emission intensity of 0.3 is observed at a wavelength of 640 nm. Meanwhile, as illustrated in (b) of Fig. 3, an LED package 10B in which the resin 12b and the red phosphors 12a are mixed in a ratio of 1:0.10, provides a spectrum in which (i) a peak wavelength having an emission intensity of 1.0 is observed at a wavelength of 440 nm and (ii) a peak wavelength having an emission intensity of 0.8 is observed at a wavelength of 640 nm.

As illustrated in (a) of Fig. 4, an LED package 10C in which the resin 12b and the red phosphors 12a are mixed in a ratio of 1:0.15, provides a spectrum in which (i) a peak wavelength having an emission intensity of 0.56 is observed at a wavelength of 440 nm and (ii) a peak wavelength having an emission intensity of 1.0 is observed at a wavelength of 640 nm.

As illustrated in (b) of Fig. 4, an LED package 10D in which the resin 12b and the red phosphors 12a are mixed in a ratio of 1:0.20, provides, a spectrum in which (i) a peak wavelength having an emission intensity of 0.4 is observed at a wavelength of 440 nm and (ii) a peak wavelength having an emission intensity of 1.0 is observed at a wavelength of 640 nm.

As described above, it is possible to easily adjust the light amount ratio of the blue region light to the red region light by changing the ratio of the resin 12b to the red phosphors 12a contained in the LED package 10 of the plant cultivation LED light source 1A.

### (Wavelength of Light Necessary for Growth of Plant)

With reference to Fig. 5, the following describes wavelengths of light which needs to be emitted for growth of a plant. Fig. 5 is a view illustrating an absorption spectrum of chlorophyll and application examples of the LED packages of the plant cultivation LED light source of Embodiment 1.

First, chlorophyll, which plays a central role in photosynthesis of a plant, does not uniformly absorb light. That is, as illustrated in Fig. 5, chlorophyll exhibits clear absorption peaks around a wavelength of 660 nm for red light and around a wavelength of 450 nm for blue light. Thus, wavelength characteristics of photosynthesis have a first peak around a wavelength of 660 nm and a second peak around a wavelength of 450 nm.

Accordingly, both a red light component and a blue light component are effective for growth of a plant in a cultivation stage, in which a plant has leaves and actively carries out photosynthesis.

Meanwhile, blue light having a wavelength of around 450 nm has an influence also on a photoresponse system, which is referred to as a high-energy response system, of a plant, and thus is essential for proper morphogenesis of a plant. For this reason, importance of the blue light component is increased in a sprouting stage and a seedling raising stage of a plant.

According to the plant cultivation LED light source 1A of Embodiment 1, as illustrated in Fig. 5, the LED package 10A of Embodiment 1 is suitable for a blue region light-absorption region of chlorophyll, and the LED package 10D of Embodiment 1 is suitable for a red region light-absorption region of chlorophyll.

As described above, the LED package 10 of the plant cultivation LED light source 1A of Embodiment 1 can be easily adapted to light absorption characteristics of chlorophyll simply by changing the ratio of the resin 12b to the red phosphors 12a to be mixed in.

In a field of optics, a photon flux density is used as a unit of light amount, for example. Note here that the photon flux density refers to a value obtained as follows. That is, in a case where a substance is irradiated with sunlight, a photon flux density is obtained by dividing the number of photons emitted to the substance for one (1) second by an area of a region of the substance which region is irradiated with the sunlight. The photon flux density is obtained by counting the number of photons. Therefore, either of (i) a photon of infrared light emitted to the substance and (ii) a photon of ultraviolet light emitted to the substance is counted as one (1) photon. However, a photochemical reaction occurs only when a photon absorbable by a pigment is emitted. For example, in a case where light unabsorbable by chlorophyll is emitted to a plant, such light is almost non-existent for the plant. Therefore, a field of photosynthesis defines a photosynthetic photon flux density or a photosynthetic photon flux for light only in a wavelength region of 400 nm to 700 nm, the light being absorbable by chlorophyll. Note that the photosynthetic photon flux refers to a value obtained by multiplying a photosynthetic photon flux density (PPFD) by an area of a region which is irradiated with light. This value is not a value simply expressed by energy of chlorophyll's absorption peak wavelengths for red region light and blue region light, but is a value expressing, by an amount of photons, energy (i.e., energy necessary for photosynthesis) corresponding to absorption spectra for the red region light and the blue region light in order to obtain a light intensity necessary for growth of a plant. The photosynthetic photon flux can be obtained from (i) spectral characteristics of light emitted from an LED light source and (ii) energy of one (1) photon at each wavelength.

Thus, in terms of the photosynthetic photon flux, the plant cultivation LED light source 1A is expressed as follows. In the case of the LED package 10A illustrated in (a) of Fig. 3, the photosynthetic photon flux is 1 µmol/s in a blue region ranging from a wavelength of 400 nm to a wavelength of 480 nm, and the photosynthetic photon flux is 1.3 µmol/s in a red region ranging from a wavelength of 620 nm to a wavelength of 700 nm. Note that these values are obtained on the basis of (i) an area of the region ranging from a wavelength of 400 nm to a wavelength of 480 nm and (ii) an area of the region ranging from a wavelength of 620 nm to a wavelength of 700 nm, respectively. A ratio of these values is expressed as follows. That is, a ratio of (i) the photosynthetic photon flux in the blue region ranging from a wavelength of 400 nm to a wavelength of 480 nm to (ii) the photosynthetic photon flux in the red region ranging from a wavelength of 620 nm to a wavelength of 700 nm is 1:1.3.

In the case of the LED package 10D illustrated in (b) of Fig. 4, the photosynthetic photon flux is 0.2 µmol/s in the blue region ranging from a wavelength of 400 nm to a wavelength of 480 nm, and the photosynthetic photon flux is 2.0 µmol/s in the red region ranging from a wavelength of 620 nm to a wavelength of 700 nm. A ratio of these values are expressed as follows. That is, a ratio of (i) the photosynthetic photon flux in the blue region ranging from a wavelength of 400 nm to a wavelength of 480 nm to (ii) the photosynthetic photon flux in the red region ranging from a wavelength of 620 nm to a wavelength of 700 nm is 1:10.

In the case of the LED package 10B illustrated in (b) of Fig. 3, a ratio of (i) the photosynthetic photon flux in the blue region ranging from a wavelength of 400 nm to a wavelength of 480 nm to (ii) the photosynthetic photon flux in the red region ranging from a wavelength of 620 nm to a wavelength of 700 nm is 1:3.5. In the case of the LED package 10C illustrated in (a) of Fig. 4, a ratio of (i) the photosynthetic photon flux in the blue region ranging from a wavelength of 400 nm to a wavelength of 480 nm to (ii) the photosynthetic photon flux in the red region ranging from a wavelength of 620 nm to a wavelength of 700 nm is 1:7.5.

According to Embodiment 1, therefore, the ratio of (i) the photosynthetic photon flux in the blue region ranging from a wavelength of 400 nm to a wavelength of 480 nm to (ii) the photosynthetic photon flux in the red region ranging from a wavelength of 620 nm to a wavelength of 700 nm is 1:1.3 to 1:10. Thus, it is possible to provide the plant cultivation LED light source 1A suitable for sprouting and raising seedlings of a plant.

Specifically, in a case where the plant cultivation LED light source 1A is to be provided on a sprouting shelf or a seedling raising shelf, it is preferable to employ the LED package 10A or 10B. This is because, with each of the LED packages 10A and 10B, the ratio of (i) the photosynthetic photon flux in the blue region ranging from a wavelength of 400 nm to a wavelength of 480 nm to (ii) the photosynthetic photon flux in the red region ranging from a wavelength of 620 nm to a wavelength of 700 nm falls within a range from 1:1.3 to 1:3.5. Thus, it is possible to provide the plant cultivation LED light source 1A including the LED package 10A or 10B suitable for sprouting and raising seedlings of a plant.

In a case where the plant cultivation LED light source 1A of Embodiment 1 is to be provided on a cultivation shelf, it is preferable to employ the LED package 10C or 10D. This is because, with each of the LED packages 10C and 10D, the ratio of (i) the photosynthetic photon flux in the blue region ranging from a wavelength of 400 nm to a wavelength of 480 nm to (ii) the photosynthetic photon flux in the red region ranging from a wavelength of 620 nm to a wavelength of 700 nm falls within a range from 1:7.5 to 1:10. Thus, it is possible to provide the plant cultivation LED light source 1A including the LED package 10A or 10B suitable for cultivation of a plant.

Fig. 6 illustrates temperature characteristics, observed in terms of a relative luminous flux, of the plant cultivation LED light source 1A of Embodiment 1 and a conventional single red LED chip for plant cultivation. In Fig. 6, a horizontal axis indicates a junction temperature of a mounted chip, and a vertical axis indicates a value of a relative luminous flux. As illustrated in Fig. 6, the plant cultivation LED light source 1A (shown by a solid line in Fig. 6) and the conventional single red LED chip for plant cultivation (shown by a broken line in Fig. 6) have a difference of approximately 10% in temperature characteristic in a high temperature region. The difference is caused by a poor temperature characteristic of the red LED chip. Meanwhile, the plant cultivation LED light source 1A of Embodiment 1 includes the red phosphors 12a instead of the red LED chip, and thus has an improved temperature characteristic. As a result, the plant cultivation LED light source 1A can be successfully adapted to a light absorption peak of a light absorption characteristic of chlorophyll.

### (Material of Red Phosphor)

As described above, CaAlSiN₃ :Eu is used as the red phosphor 12a of the plant cultivation LED light source 1A of Embodiment 1. Note, however, that the red phosphor 12a is not limited to such a material, but (Sr,Ca)AlSiN₃ :Eu can be used as the red phosphor 12a, for example. (Sr,Ca)AlSiN₃ is a phosphor which (i) is obtained by replacing a part of Ca of CaAlSiN₃ :Eu with Sr so that a wavelength at which a light emission peak is exhibited is shifted to a shorter wavelength and (ii) has a stable temperature characteristic and high luminous efficiency as with CaAlSiN₃ :Eu.

Specifically, particularly for a plant containing more chlorophyll a than chlorophyll b, for example, it is preferable to use CaAlSiN₃ :Eu (light emission peak: 650 nm to 660 nm) as the red phosphor 12a. Meanwhile, for a plant containing more chlorophyll b than chlorophyll a, it is preferable to use, as the red phosphor 12a, (Sr,Ca)AlSiN₃ :Eu, which exhibits a light emission peak at a shorter wavelength (620 nm to 630 nm).

Alternatively, it is possible to use, as the red phosphor 12a, 3.5MgO·0.5MgF₂·GeO₂ :Mn, La₂ O₂ S:Eu, Y₂ O₂ S:Eu, LiEuW₂ O₈, (Y,Gd,Eu)₂ O₃, (Y,Gd,Eu)BO₃, and/or YVO₄ :Eu, CaS:Eu,Ce,K.

It is needless to say that two types of red phosphors 12a, such as CaAlSiN₃ :Eu and (Sr,Ca)AlSiN₃ :Eu, can be used in combination. Use of the two types of red phosphors 12a in combination is effective for cultivating a plant equally containing chlorophyll a and chlorophyll b.

In regard to a light absorption characteristic for a blue region light of chlorophyll, the blue LED chip 11 can be selected as appropriate so that a peak wavelength of the blue LED chip 11 matches an absorption peak of chlorophyll a and/or chlorophyll b. For example, for a plant containing more chlorophyll a than chlorophyll b, it is preferable to use a blue LED chip 11 (type I) exhibiting a peak at a wavelength in a range of 430 nm to 440 nm. Meanwhile, for a plant containing more chlorophyll b than chlorophyll a, it is preferable to use a blue LED chip 11 (type II) exhibiting a peak at a wavelength of 450 nm to 460 nm.

Further, the blue LED chip 11 and the red phosphors 12a may be used in combination so as to be suitable for a selected one of (i) the plant containing more chlorophyll a than chlorophyll b and (ii) the plant containing more chlorophyll b than chlorophyll a. For example, the plant cultivation LED light source 1A can be configured such that (i) the blue LED chip 11 of type I and the red phosphors 12a made of CaAlSiN₃ :Eu are used in combination or (ii) the blue LED chip 11 of type II and the red phosphors 12a made of (Sr,Ca)AlSiN₃ :Eu are used in combination.

In this case, the ratio of the resin 12b to the red phosphors 12a is adjusted as appropriate so that a desired light amount ratio is obtained.

### (Configuration of Illumination LED Light Source Necessary for Human Operation)

The plant cultivation LED light source 1A described above is an LED light source for plant cultivation. However, the plant cultivation LED light source 1A can be easily configured to include an LED package 10E which is necessary for human operation.

Specifically, it is possible to provide, as an LED package 10 for illumination in the plant cultivation LED light source 1A, the LED package 10E in which not only the red phosphors 12a but also green phosphors are mixed and dispersed in the resin 12b of the red phosphor mixed resin 12 covering an upper side of the blue LED chip 11.

In this case, the LED package 10E is configured such that a ratio between the resin 12b, the red phosphors 12a, and green phosphors 7c is, for example, 1:0.01:0.10. This ratio makes it possible to provide a light emission spectrum shown in Fig. 7. According to the light emission spectrum shown in Fig. 7, an amount of light having a wavelength of approximately 550 nm, around which light is brightest to human eyes, is increased. Accordingly, the plant cultivation LED light source 1A including the LED package 10E for illumination is effective as an illumination light source for human operation.

### [Embodiment 2]

Another embodiment of the present invention is described below with reference to Figs. 8 through 12. Note that configurations other than those described in Embodiment 2 are identical to the configurations described in Embodiment 1. For convenience of description, members having the functions identical to those illustrated in the drawing of Embodiment 1 are given the identical reference signs, and descriptions on such members are omitted.

The plant cultivation LED light source 1A described in Embodiment 1 includes the substrate 2A made of ceramic and the single LED package 10 provided on the substrate 2A.

Meanwhile, a plant cultivation LED light source 1B of the Embodiment 2 includes a substrate 2B made of a film-like base material, and differs from the plant cultivation LED light source 1A in this point.

### (Configuration of Plant Cultivation LED Light Source)

The following describes a configuration of the plant cultivation LED light source 1B of the Embodiment 2 with reference to (a) and (b) of Fig. 8 through (a) and (b) of Fig. 11. (a) of Fig. 8 is a cross sectional view illustrating a configuration of a plant cultivation LED light source of the Embodiment 2. (b) of Fig. 8 is a plan view illustrating a configuration of a plant cultivation LED light source, in which plan view no red phosphor mixed resin or silicone resin is illustrated. (a) of Fig. 9 is a side view illustrating a configuration of a plant cultivation LED light source including (i) a mounting substrate made of a film-like base material, (ii) a substrate provided on the mounting substrate and made of a film-like base material, and (iii) a plurality of LED packages provided on the substrate, the mounting substrate being warped. (b) of Fig. 9 is a side view illustrating a configuration of a plant cultivation LED light source including (i) a substrate made of a film-like base material and (ii) a plurality of LED packages provided on the substrate, the substrate being warped. (a) of Fig. 10 is a perspective view illustrating a configuration of a plant cultivation LED light source including (i) a mounting substrate having a strip shape and (ii) a plurality of LED packages arranged on the mounting substrate. (b) of Fig. 10 is a perspective view illustrating a configuration of a plant cultivation LED light source including (i) a mounting substrate having a rectangular shape and (ii) a plurality of LED packages arranged on the mounting substrate. (a) of Fig. 11 is a plan view illustrating a configuration of a plant cultivation LED light source including (i) a substrate and (ii) a plurality of blue LED chips electrically connected in parallel on the substrate. (b) of Fig. 11 is a plan view illustrating a configuration of a plant cultivation LED light source including (i) a substrate and (ii) a plurality of blue LED chips electrically connected in parallel on the substrate.

That is, as illustrated in (a) and (b) of Fig. 8, according to the plant cultivation LED light source 1B of the Embodiment 2, the substrate 2B is made of a film-like base material. Preferably used as the film-like base material is, for example, a thin and hard resin film such as a polyimide film. This makes it possible to provide not only the plant cultivation LED light source 1B having a plane surface but also the plant cultivation LED light source 1B having a curved surface as illustrated in (a) and (b) of Fig. 9. That is, it is possible to provide, as illustrated in (a) of Fig. 9, the plant cultivation LED light source 1B including (i) the mounting substrate 6 made of the film-like base material, (ii) the substrate 2B provided on the mounting substrate 6 and made of the film-like base material, and (iii) the plurality of LED packages 10 provided on the substrate 2B, the mounting substrate 6 being warped. In this case, the substrate 2B is made of the film-like base material. Therefore, even in a case where the mounting substrate 6 made of the film-like base material is warped, the substrate 2B made of the film-like base material can also be warped along with the warpage of the mounting substrate 6. Note that a material of the mounting substrate 6 is not necessarily limited to the film-like base material, but the mounting substrate 6 can be, for example, a mounting section which is made of a material such as metal or resin and has a curved surface.

Alternatively, as illustrated in (b) of Fig. 9, the plant cultivation LED light source 1B can be configured to include (i) the substrate 2B made of the film-like base material and (ii) the plurality of LED packages directly provided on the substrate 2B, the substrate 2B being warped.

This consequently makes it possible to more effectively use a space where the plant cultivation LED light source 1B is to be provided, thereby reducing a limitation to a place where the plant cultivation LED light source 1B is to be provided. In particular, it is preferable to use a resin film made of polyimide and having a film shape. This is because that such resin film is hard and has elasticity and flexibility, and therefore the resin film allows many LED packages 10 to be provided on its plane surface and can be warped for use.

As with the plant cultivation LED light source 1A of Embodiment 1, the plant cultivation LED light source 1B of the Embodiment 2 includes at least one blue LED chip 11 provided on the substrate 2B (see (a) and (b) of Fig. 8). The red phosphor mixed resin 12, in which the red phosphors 12a are dispersed or settled down, is provided around the blue LED chip 11 so as to cover the blue LED chip 11. Further, the transparent silicone resin 13 is provided so as to cover the red phosphor mixed resin 12. The plant cultivation LED light source 1B of the Embodiment 2 therefore includes, on the substrate 2B, the LED package 10 in which the blue LED chip 11 is double-sealed with the red phosphor mixed resin 12 and the silicone resin 13.

According to the plant cultivation LED light source 1B, as illustrated in (b) of Fig. 8, the blue LED chip 11 is provided on the substrate 2B which (i) is made of, for example, polyimide and (ii) has a film shape. The blue LED chip 11 is connected, via wires 4, to electrode terminals 5 which are provided on both sides, respectively.

Note here that a shaded part in (b) of Fig. 8 indicates a protection element. The protection element refers to a printed resistor, which is a Zener diode. However, the present invention does not necessarily include the protection element.

According to the Embodiment 2, an electric connection is made via the wires 4 by use of the blue LED chip 11. Instead of the blue LED chip 11 including the two electrodes, a flip-chip blue LED chip 11 can be used. The flip-chip blue LED chip 11 requires no wire 4, and thus reduces the possibility of lighting failure caused by, for example, a disconnection of the wire 4. Further, the flip-chip blue LED chip 11 requires no wire 4 made of, for example, gold. This makes it possible to provide the plant cultivation LED light source 1B at a low price.

Note that configurations of the blue LED chips 11, the red phosphor mixed resin 12, and the silicone resin 13 are identical to those of the plant cultivation LED light source 1A of Embodiment 1, and thus descriptions on such members are omitted.

Note that according to the plant cultivation LED light source 1B of the Embodiment 2, the number of LED packages 10 provided on the substrate 2B is not necessarily limited to one (1), but a plurality of LED packages 10 can be provided on the substrate 2B. Specifically, for example, it is possible to (i) provide a plurality of LED packages 10 in a line on a mounting substrate 6 having a strip shape as illustrated in (a) of Fig. 10 or (ii) provide a plurality of LED packages 10 in matrix on a mounting substrate 6 having a rectangular shape as illustrated in (a) of Fig. 10. Accordingly, the plant cultivation LED light source 1A of the Embodiment 2 can be (i) a single-piece plant cultivation LED light source 1A including a single LED package 10 provided on the mounting substrate 6 or (ii) a bar-shaped plant cultivation LED light source 1A including the plurality of LED packages 10 provided on the mounting substrate 6 having a rectangular shape. Thus, it is possible to provide the plurality of LED packages 10 on the single mounting substrate 6 so that the plurality of LED packages 10 are closely adjacent to each other. Note that this effect can also be achieved by the plant cultivation LED light source 1A of Embodiment 1.

In this case, the plurality of LED packages 10 are not limited to be a single type. Alternatively, different types of LED packages 10 which are different in a light amount ratio of blue region light to red region light can be provided in combination. Thus, thanks to the different types of LED packages 10 provided on the single substrate 2B, it is possible to provide a light emission spectrum necessary for each growing process of a plant.

That is, in a stage before sprouting in a growing process of a photosynthetic organism such as a plant or algae, a necessary light amount ratio of (i) blue wavelength light in a short wavelength range to (ii) red wavelength light in a longer wavelength range than that of the blue wavelength light is merely approximately 1:1. However, in a sprouting stage, a necessary light amount ratio of (i) blue wavelength light in a short wavelength range to (ii) red wavelength light in a longer wavelength range than that of the blue wavelength light is approximately 1:1.5. Further, in a growing stage, a necessary light amount ratio of (i) blue wavelength light in a short wavelength range to (ii) red wavelength light in a longer wavelength range than that of the blue wavelength light is approximately 1:3.0.

Accordingly, the plant cultivation LED light source 1B is preferably configured such that the light amount ratio of (i) blue wavelength light in a short wavelength range to (ii) red wavelength light in a longer wavelength range than that of the blue wavelength light can be changed according to each stage (such as the stage before sprouting) of the growing process of the organism such as a plant or algae.

In order to deal with this, as the plurality of LED packages 10 provided on the substrate 2B, three types of LED packages 10 which have different light amount ratios for respective stages of the growing process of the organism are prepared. With this, it is possible to emit (i) blue wavelength light and (ii) red wavelength light in a longer wavelength range than that of the blue wavelength light which are in a light amount ratio suitable for each of the stages of the growing process of the organism. As a result, it is possible to surely provide the plant cultivation LED light source 1B suitable for plant cultivation.

In this case, connection of the plurality of blue LED chips 11 may be made as follows. That is, as illustrated in (a) of Fig. 11, the LED packages 10 are connected in parallel in accordance with the types of the LED packages 10. Meanwhile, the LED packages 10 of the same type are connected in series as illustrated in (b) of Fig. 11.

### (Example Arrangement of a Plurality of Types of LED packages)

With reference to (a) through (c) of Fig. 12, the following describes examples how the plural different types of LED packages 10 being different in a light amount ratio of (i) blue region emission light to (ii) red region emission light are provided in combination on the substrate 2B having a film shape. Each of (a) through (c) of Fig. 12 is a plan view illustrating an example configuration of a plant cultivation LED light source in which different types of LED packages being different in a light amount ratio of (i) blue region emission light to (ii) red region emission light are arranged in combination on a substrate. Note that such an example arrangement is applicable to Embodiment 1 and to a configuration in which the plurality of LED packages 10 are arranged on the mounting substrate 6.

For example, as illustrated in (a) of Fig. 12, LED packages 10F, LED packages 10A', and LED packages 10B' can be alternately arranged in combination in matrix on the mounting substrate 6. In this case, the LED packages 10F are each configured such that a ratio of (i) a photosynthetic photon flux in a blue region ranging from a wavelength of 400 nm to a wavelength of 480 nm to (ii) a photosynthetic photon flux in a red region ranging from a wavelength of 620 nm to a wavelength of 700 nm is 1:1, for example. The LED packages 10A' are each configured such that a ratio of (i) a photosynthetic photon flux in a blue region ranging from a wavelength of 400 nm to a wavelength of 480 nm to (ii) a photosynthetic photon flux in a red region ranging from a wavelength of 620 nm to a wavelength of 700 nm is 1:1.5, for example. The LED packages 10B' are each configured such that a ratio of (i) a photosynthetic photon flux in a blue region ranging from a wavelength of 400 nm to a wavelength of 480 nm to (ii) a photosynthetic photon flux in a red region ranging from a wavelength of 620 nm to a wavelength of 700 nm is 1:3, for example.

In the above example, used in the stage before sprouting are the LED packages 10F, in each of which the ratio of the photosynthetic photon fluxes is 1:1, for example. Used in the sprouting stage are the LED packages 10A', in each of which the ratio of the photosynthetic photon fluxes is 1:1.5, for example. Used in the seedling raising stage are the LED packages 10B', in each of which the ratio of the photosynthetic photon fluxes is 1:3, for example.

This makes it possible to provide the plant cultivation LED light source 1B suitable for the stage before sprouting, the sprouting stage, and the seedling raising stage of a plant.

According to the example arrangement illustrated in (a) of Fig. 12, in a case where (i) the LED packages 10F ,in each of which the ratio of the photosynthetic photon fluxes is, e.g., 1:1 and (ii) the LED packages 10B', in each of which the ratio of the photosynthetic photon fluxes is, e.g., 1:3 are simultaneously turned on, it is possible to obtain light corresponding to light to be emitted from the LED packages 10A', in each of which the ratio of the photosynthetic photon fluxes is, e.g., 1:1.5. This makes it possible to obtain a ratio of the photosynthetic photon fluxes of 1:1.5, which is substantially equal to that of each of the LED packages 10A.

Thus, for example, as illustrated in (b) of Fig. 12, it is possible to alternately arrange in matrix (i) the LED packages 10F, in each of which the ratio of the photosynthetic photon fluxes is, e.g., 1:1 and (ii) the LED packages 10B', in each of which the ratio of the photosynthetic photon fluxes is, e.g., 1:3. In this case, in the stage before sprouting, the LED packages 10F, in each of which the ratio of the photosynthetic photon fluxes is, e.g., 1:1 are used. In the sprouting stage, (i) the LED packages 10F, in each of which the ratio of the photosynthetic photon fluxes is, e.g., 1:1 and (ii) the LED packages 10B', in each of which the ratio of the photosynthetic photon fluxes is, e.g., 1:3 are used by simultaneously being turned on. In the seedling raising stage, the LED packages 10B', in each of which the ratio of the photosynthetic photon fluxes is, e.g., 1:3, are used. This makes it possible to provide the plant cultivation LED light source 1B suitable for the stage before sprouting, the sprouting stage, the seedling raising stage, and the cultivation stage of a plant by use of only the two types of LED packages, i.e., the LED packages 10F and the LED packages 10B'.

In some cases, the plant cultivation LED light source 1B of the Embodiment 2 is desired to be used for illumination. In such cases, the LED package 10E for illumination described in Embodiment 1 is used. As described above, according to the LED package 10E for illumination, the ratio between the resin 12b, the red phosphors 12a, and the green phosphors 7c is, for example, 1:0.01:0.10. As illustrated in Fig. 7, the LED package 10E for illumination has such a light emission spectrum that an amount of light having a wavelength of approximately 550 nm, around which light is brightest to human eyes, is increased.

An example arrangement of the LED packages 10E for illumination on the mounting substrate 6 is illustrated in (c) of Fig. 12. In this case, (i) the LED packages 10F, in each of which the ratio of the photosynthetic photon fluxes is, e.g., 1:1, (ii) the LED packages 10B', in each of which the ratio of the photosynthetic photon fluxes is, e.g., 1:3, and (iii) the LED packages 10E for illumination are alternately arranged in matrix.

In the stage before sprouting, the LED packages 10F, in each of which the ratio of the photosynthetic photon fluxes is, e.g., 1:1, is used. In the sprouting stage, (i) the LED packages 10F, in each of which the ratio of the photosynthetic photon fluxes is, e.g., 1:1 and (ii) the LED packages 10B', in each of which the ratio of the photosynthetic photon fluxes is, e.g., 1:3 are used by simultaneously being turned on. In the seedling raising stage, the LED packages 10B', in each of which the ratio of the photosynthetic photon fluxes is, e.g., 1:3, is used. For illumination, the LED packages 10E for illumination are turned on.

This makes it possible to provide the plant cultivation LED light sources 1B suitable for (i) the stage before sprouting, the sprouting stage, and the seedling raising period stage of a plant and (ii) illumination by use of only three types of LED packages, i.e., the LED packages 10F, the LED packages 10B', and the LED packages 10E for illumination.

### [Embodiment 3]

Still another embodiment of the present invention is described below. Note that configurations other than those described in Embodiment 3 are identical to the configurations described in Embodiments 1 and 2. For convenience of description, members having the functions identical to those illustrated in the drawing of Embodiments 1 and 2 are given the identical reference signs, and descriptions on such members are omitted.

Embodiments 1 and 2 have described the plant cultivation LED light sources 1A and 1B to be used for a plant which requires light for carrying out photosynthesis for growth. However, the plant cultivation LED light source of the present invention is also applicable to algae which require light for carrying out photosynthesis for growth. Embodiment 3 thus describes how the plant cultivation LED light source of the present invention is applied to photosynthetic algae.

That is, examples of photosynthetic pigments other than chlorophyll a and b encompass (i) chlorophyll c and bacterio chlorophyll a (835 nm) of a chlorophyll pigment system, (ii) β-carotene (446 nm), lutein, and fucoxanthin (453 nm) of a carotenoid pigment system, and (iii) phycocyanin (612 nm) and phycoerythrin (540 nm) of a phycobilin pigment system. Note that values shown in parentheses each indicate an absorption peak wavelength of a respective photosynthetic pigment. As described above, bacterio chlorophyll has an absorption peak wavelength at 700 nm or greater.

Specifically, these types of algae have the following pigments.

First, diatoms have chlorophyll a and fucoxanthin (453 nm) as primary pigments. As described above, chlorophyll a has an absorption peak at a wavelength in a range of 400 nm to 450 nm in the blue light region and an absorption peak at a wavelength in a range of 650 nm to 660 nm in the red light region.

In this case, therefore, a plant cultivation LED light source of Embodiment 3 includes at least one blue LED chip 11, a red phosphor mixed resin 12 which covers the blue LED chip 11, and a silicone resin 13 which covers the red phosphor mixed resin 12. The blue LED chip 11 included in this plant cultivation LED light source emits first short wavelength range light corresponding to, among a plurality of peak wavelengths of light absorbed by diatoms which require light for carrying out photosynthesis for growth, a first peak wavelength of fucoxanthin of 453 nm which first peak wavelength is in a relatively short wavelength range. Further, the red phosphor mixed resin 12 preferably contains, as phosphors, red phosphors 12a each absorbing the first short wavelength range light emitted from the blue LED chip 11 and then emitting long wavelength range light corresponding to, among the plurality of peak wavelengths, a peak wavelength of chlorophyll a which is in a range of 650 nm to 660 nm and is in a longer wavelength range than the first peak wavelength of 453 nm. This makes it possible to promote growth of diatoms.

In the case of diatoms, the plant cultivation LED light source of Embodiment 3 can include at least one second LED chip for emitting second short wavelength range light corresponding to, among a plurality of peak wavelengths, a second peak wavelength of chlorophyll a which is in a range of 400 nm to 450 nm, is in a relatively short wavelength range, and is different from the first peak wavelength of fucoxanthin of 453 nm. This makes it possible to further promote the growth of diatoms.

Next, green algae have chlorophyll a and b and β-carotene (446 nm) as primary pigments. As described above, chlorophyll a has an absorption peak at a wavelength in a range of 400 nm to 450 nm in the blue region, and has an absorption peak at a wavelength in a range of 650 nm to 660 nm in the red region. Meanwhile, chlorophyll b has an absorption peak wavelength in a range of 400 nm to 480 nm in the blue region, and has an absorption peak wavelength of 620 nm to 630 nm in the red region.

In this case, therefore, a plant cultivation LED light source of Embodiment 3 includes at least one blue LED chip 11, a red phosphor mixed resin 12 which covers the blue LED chip 11, and a silicone resin 13 which covers the red phosphor mixed resin 12. The blue LED chip 11 included in this plant cultivation LED light source emits first short wavelength range light corresponding to, among a plurality of peak wavelengths of light absorbed by green algae which require light for carrying out photosynthesis for growth, a first peak wavelength of β-carotene of 446 nm which first peak wavelength is in a relatively short wavelength range. The red phosphor mixed resin 12 preferably contains red phosphors each absorbing the first short wavelength range light emitted from the blue LED chip 11 and then emitting long wavelength range light corresponding to, among the plurality of peak wavelengths, a peak wavelength of chlorophyll a which is in a range of 650 nm to 660 nm and a peak wavelength of chlorophyll b which is in a range of 620 nm to 630 nm and is in a longer wavelength range than the first peak wavelength of 446 nm. This makes it possible to promote growth of green algae.

Next, blue-green algae have chlorophyll a and phycocyanin (612 nm) as primary pigments. As described above, chlorophyll a has an absorption peak at a wavelength in a range of 400 nm to 450 nm in the blue region.

In this case, therefore, a plant cultivation LED light source of Embodiment 3 includes at least one blue LED chip 11, a red phosphor mixed resin 12 which covers the blue LED chip 11, and a silicone resin 13 which covers the red phosphor mixed resin 12. The blue LED chip 11 included in the plant cultivation LED light source emits first short wavelength range light corresponding to, among a plurality of peak wavelengths of light absorbed by blue-green algae which require light for carrying out photosynthesis for growth, a first peak wavelength of chlorophyll a of 400 nm to 450 nm which first peak wavelength is in a relatively short wavelength range. The red phosphor mixed resin 12 preferably contains red phosphors 12a each absorbing the first short wavelength range light emitted from the blue LED chip 11 and then emitting long wavelength range light corresponding to, among the plurality of peak wavelengths, a peak wavelength of phycocyanin which is 612 nm and is in a longer wavelength range than the first peak wavelength in a range of 400 nm to 450 nm. This makes it possible to promote growth of blue-green algae.

In this case, it is also possible to use a blue LED chip 11 emitting light corresponding to an absorption peak wavelength of the red phosphors 12a.

That is, first, the plant cultivation LED light source of Embodiment 3 includes at least one first blue LED chip 11 and a red phosphor mixed resin 12 which covers the first blue LED chip. The first blue LED chip 11 included in the plant cultivation LED light source emits first short wavelength range light corresponding to a first peak wavelength of chlorophyll a in a range of 400 nm to 450 nm which first peak wavelength is in a relatively short wavelength range. The red phosphor mixed resin 12 contains first red phosphors absorbing the first short wavelength range light emitted from the first blue LED chip. Then, the first red phosphors emit long wavelength range light corresponding to, among a plurality of peak wavelengths, a peak wavelength of chlorophyll a in a range of 650 nm to 660 nm which peak wavelength is in a longer wavelength range than the first peak wavelength in a range of 400 nm to 450 nm.

Next, the plant cultivation LED light source includes at least one second blue LED chip for emitting second short wavelength range light corresponding to a second peak wavelength which is in a relatively short wavelength range and is different from the first peak wavelength of chlorophyll a in a range of 400 nm to 450 nm.

For the second blue LED chip, a red phosphor mixed resin 12 is provided that contains second red phosphors each absorbing first short wavelength range light emitted from the second blue LED chip, and then emitting long wavelength range light corresponding to, among the plurality of peak wavelengths, a peak wavelength of phycocyanin of 612 nm which is in a longer wavelength range than the first peak wavelength in a range of 400 nm to 450 nm.

With this configuration, in a case where the first red phosphors of the first blue LED chip, which emits the first short wavelength range light, cannot emit long wavelength range light corresponding to a peak wavelength of phycocyanin of 612 nm which is in a relatively long wavelength range, the second blue LED chip, which emits the second short wavelength range light, is used. This allows the second red phosphors to emit long wavelength range light corresponding to the peak wavelength of phycocyanin of 612 nm.

This consequently allows the light-emitting device to emit, to phycocyanin, red wavelength region light having a higher light emission intensity. This leads to fine growth of blue-green algae.

Note that such a method can be used for cultivation and culture of other organisms as well as blue-green algae.

It is possible to promote growth of algae such as diatoms, green algae, and blue-green algae by emitting light to the algae such as diatoms, green algae, and blue-green algae by use of the plant cultivation LED light source described above.

Further, even for an organism exhibiting two peak wavelengths, i.e., a first peak wavelength and a second peak wavelength in a relatively short wavelength range, it is possible to provide a plant cultivation LED light source which properly promotes growth of the organism such as algae.

### (Conclusion)

Plant cultivation LED light sources 1A and 1B of a first aspect of the present invention are each configured to include: a substrate 2A or a substrate 2B; at least one blue LED chip 11, provided on the substrate 2A or the substrate 2B, for emitting blue light ; a red phosphor mixed resin 12 which is provided so as to cover the blue LED chip 11 and contains red phosphors 12a being dispersed or settled down therein, each of the red phosphors 12a emitting red light in response to excitation light emitted from the blue LED chip 11; and a silicone resin 13 which is transparent and is provided so as to cover the red phosphor mixed resin 12.

For growth of photosynthetic organisms such as a plant or algae, many of the photosynthetic organisms require relatively-blue light and red light which is in a wavelength region longer than that of blue light. In view of this, the present invention includes: (i) at least one blue LED chip for emitting blue light and (ii) red phosphor mixed resin which is provided so as to cover the blue LED chip and contains red phosphors being dispersed or settled down therein, each of the red phosphors emitting red light in response to excitation light emitted from the blue LED chip.

Thus, with use of a single type of blue LED chip, this configuration makes it possible to emit light corresponding to (i) an absorption peak in a blue region of, for example, chlorophyll and (ii) an absorption peak in a red region due to the red phosphors which light is necessary for growth of an organism such as a plant or algae. This is achieved without use of two types of LED chips, i.e., an independent blue LED chip and an independent red LED chip. Therefore, it is possible to prevent an increase in an area where the plant cultivation LED light source is to be mounted. Further, since this configuration does not include a red LED, it is possible to avoid a problem of a short service life of the plant cultivation LED light source.

Further, in the case where the two types of LED chips, i.e., the independent blue LED chip and the independent red LED chip are used, it is difficult to control mixing of colors of blue light and red light. However, according to the configuration of the present invention, the red phosphors are dispersed or settled down in the red phosphor mixed resin. This allows the red phosphors to be dispersed in the red phosphor mixed resin in a certain ratio. Thus, by changing the ratio, it is possible to change an amount of blue region light and an amount of red region light. Further, since a mixed color spectrum is obtained from a single plant cultivation LED light source, a distance between a plant and the silicone resin, which is a light-emitting surface, can be reduced as compared with a conventional plant cultivation LED light source. This reduces a loss of light from emission light of the plant cultivation LED light source. According to the conventional light source including two types of LED chips, i.e., an independent blue LED chip and an independent red LED chip, a considerable distance is necessary between the plant and the light source for mixing colors of blue light and red light. According to the present invention, however, the colors are mixed on a surface of the silicone resin, so that the plant cultivation LED light source can be placed so as to be closer to a plant.

Thus, according to the present invention, it is possible to provide the plant cultivation LED light source which has a simple configuration and enables (i) easy adjustment of a light amount ratio of blue region light to red region light and (ii) emission of mixed color light in which blue light and red light are mixed and which is less spatially uneven, without increasing an area for mounting.

The plant cultivation LED light source according to the present invention includes the transparent silicone resin covering the red phosphor mixed resin. Accordingly, the silicone resin acts as a lens. Thus, refraction given by the silicone resin, which acts as a lens, makes it possible to converge light in a given direction. As a result, light emitted from the blue LED chip and the red phosphor mixed resin can reach a more distant position. This makes it possible to increase an amount of light to be emitted to a plant in a distant position, thereby increasing light extraction efficiency. As a result, according to the plant cultivation LED light source of the present invention, the number of LED packages provided for obtaining necessary luminance can be reduced as compared with the conventional light-emitting device including a blue LED chip and a red LED chip, and thus it is possible to reduce electric power consumption.

Thus, it is possible to provide the plant cultivation LED light source with which light extraction efficiency is increased.

In addition to the configurations of the plant cultivation LED light sources 1A and 1B of the first aspect, plant cultivation LED light sources 1A and 1B of a second aspect of the present inventions are each configured such that the substrate 2A or the substrate 2B is made of ceramic or a film-like base material.

In a case where ceramic is used as the substrate, it is possible to provide a base material having a high heat insulation performance. Further, in a case where the film-like base material is used as the substrate, it is possible to provide not only a plant cultivation LED light source having a plane surface but also a plant cultivation LED light source having a curved surface. This makes it possible to effectively use an area where the plant cultivation LED light source is to be mounted.

In addition to the configurations of the plant cultivation LED light sources 1A and 1B of the first or second aspect, plant cultivation LED light sources 1A and 1B of a third aspect of the present inventions are each configured such that each of the red phosphor mixed resin 12 and the silicone resin 13 has a dome shape.

With the red phosphor mixed resin and the silicone resin each having a dome shape, it is possible to emit light uniformly and radially in a wide range.

In addition to the configurations of the plant cultivation LED light sources 1A and 1B of the first, second, or third aspect, plant cultivation LED light sources 1A and 1B of a fourth aspect of the present inventions are each configured such that the blue LED chip 11 emits light having a light emission peak at a wavelength in a range of 400 nm to 480 nm; and each of the red phosphors 12a emits light having a light emission peak at a wavelength in a range of 620 nm to 700 nm.

According to the above-described invention, the plant cultivation LED light source includes: a substrate; at least one blue LED chip; a red phosphor mixed resin which covers the blue LED chip and in which red phosphors are dispersed; and a silicone resin which covers the red phosphor mixed resin.

Further, according to the above configuration of the present invention, the blue LED chip is able to emit light having a wavelength in a range of 400 nm to 480 nm for the absorption peak in the blue region of chlorophyll. Further, the red phosphors each emit, in response to excitation light emitted from the blue LED chip, light having a light emission peak at a wavelength in a range of 620 nm to 700 nm for the absorption peak in the red region of chlorophyll.

As a result, with use of a single type of blue LED chip, this configuration makes it possible to emit light corresponding to (i) the absorption peak in the blue region of, for example, chlorophyll and (ii) the absorption peak in the red region which light is necessary for growth of a plant. This is achieved without use of two types of LED chips, i.e., an independent blue LED chip and an independent red LED chip. Therefore, it is possible to prevent an increase in an area where the plant cultivation LED light source is to be mounted. According to the configuration, the red phosphors are dispersed or settled down in the red phosphor mixed resin. This allows the red phosphors to be dispersed in the red phosphor mixed resin in a certain ratio. Thus, by changing the ratio, it is possible to change an amount of blue region light and an amount of red region light.

This makes it possible to provide the plant cultivation LED light source which (i) has a simple configuration and prevents an installation area from being increased and (ii) is capable of easily (a) adjusting a light amount ratio of light in a blue region to be emitted and light in a red region to be emitted and also (b) emitting mixed color light of blue light and red light which mixed color has less unevenness in space.

In addition to the configurations of the plant cultivation LED light sources 1A and 1B of any one of the first through fourth aspects, plant cultivation LED light sources 1A and 1B of a fifth aspect of the present inventions are each configured such that a plurality of LED packages 10 are provided on the substrate 2A or the substrate 2B, each of the plurality of LED packages 10 including the blue LED chip 11, the red phosphor mixed resin 12, and the silicone resin 13, the red phosphor mixed resin 12 and the silicone resin 13 being provided so as to cover the blue LED chip 11, and as the plurality of LED packages 10, LED packages having different light amount ratios of blue region emission light to red region emission light are provided in combination.

That is, in a stage before sprouting in a growing process of a photosynthetic organism such as a plant or algae, a necessary light amount ratio of (i) blue wavelength light in a short wavelength range to (ii) red wavelength light in a longer wavelength range than that of the blue wavelength light is merely approximately 1:1. However, in a sprouting stage , a necessary light amount ratio of (i) blue wavelength light in a short wavelength range to (ii) red wavelength light in a longer wavelength range than that of the blue wavelength light is approximately 1:1.5. Further, in a growing stage, a necessary light amount ratio of (i) blue wavelength light in a short wavelength range to (ii) red wavelength light in a longer wavelength range than that of the blue wavelength light is approximately 1:3.0.

Accordingly, the plant cultivation LED light source is preferably configured such that the light amount ratio of (i) blue wavelength light in a short wavelength range to (ii) red wavelength light in a longer wavelength range than that of the blue wavelength light can be changed according to each stage (such as the stage before sprouting) of the growing process of the organism such as a plant or algae.

With this respect, the plant cultivation LED light source of the present invention includes the substrate on which the plurality of LED packages, each of which includes the blue LED chip covered with the red phosphor mixed resin and the silicone resin, are provided. As the plurality of LED packages, LED packages which have different light amount ratios of blue region light to red region light are arranged in combination.

Accordingly, as the plurality of LED packages provided on the substrate, for example, three types of LED packages 10 which have different light amount ratios for respective stages of the growing process of the organism may be provided. With this configuration, it is possible to emit (i) blue wavelength light and (ii) red wavelength light in a longer wavelength range than that of the blue wavelength light which are in a light amount ratio suitable for each of the stages of the growing process of the organism.

Accordingly, it is possible to surely provide the plant cultivation LED light source suitable for plant cultivation. Further, with use of a single element, it is possible to obtain, on the single substrate, a light emission spectrum necessary for each of the stages of the growing process of a plant.

In addition to the configurations of the plant cultivation LED light sources 1A and 1B of any one of the first through fifth aspects, plant cultivation LED light sources 1A and 1B of a sixth aspect of the present invention can be configured to each include, as the blue LED chip 11, (i) at least one blue LED chip for chlorophyll a for emitting light exhibiting a light emission peak at a wavelength in a range of 400 nm to 450 nm for the absorption peak in the blue region of chlorophyll a and (ii) at least one blue LED chip for chlorophyll b for emitting light exhibiting a light emission peak at a wavelength in a range of 400 nm to 480 nm for the absorption peak in the blue region of chlorophyll b.

A plant has chlorophyll a and chlorophyll b. Chlorophyll a and chlorophyll b have different light absorption characteristics in the blue region. Specifically, chlorophyll a has an absorption peak at a wavelength of 400 nm to 450 nm in the blue region, whereas chlorophyll b has an absorption peak at a wavelength of 400 nm to 480 nm in the blue region.

In view of this, according to the present invention, in order to deal with the two types of light absorption characteristics of chlorophyll a and chlorophyll b in the blue region, the plant cultivation LED light source includes (i) at least one blue LED chip for chlorophyll a for emitting light exhibiting a light emission peak at a wavelength in a range of 400 nm to 450 nm for the absorption peak in the blue region of chlorophyll a and (ii) at least one blue LED chip for chlorophyll b for emitting light exhibiting a light emission peak at a wavelength in a range of 400 nm to 480 nm for the absorption peak in the blue region of chlorophyll b.

This consequently makes it possible to provide the plant cultivation LED light source more suitable for a plant containing chlorophyll a and chlorophyll b.

Note that the present invention is not limited to the description of the embodiments above, but may be altered by a skilled person within the scope of the claims. An embodiment based on a proper combination of technical means disclosed in different embodiments is encompassed in the technical scope of the present invention.

### Industrial Applicability

The present invention is applicable to a plant cultivation LED light source for emitting light to be absorbed by a plant which requires light for carrying out photosynthesis for growth.

### Reference Signs List

1A: Plant cultivation LED light source
1B: Plant cultivation LED light source
2A: Substrate
2B: Substrate
3: Electrode
4: Wire
5: Electrode terminal
6: Mounting substrate
10: LED package
10A: LED package
10A': LED package
10B: LED package
10B': LED package
10C: LED package
10D: LED package
10E: LED package
10F: LED package
11: Blue LED chip
12: Red phosphor mixed resin
12a: Red phosphor
12b: Resin
13: Silicone resin

## Claims

1. A plant cultivation LED light source, comprising:
a substrate;
at least one blue LED chip, provided on the substrate, for emitting blue light;
a red phosphor mixed resin which is provided so as to cover the blue LED chip and contains red phosphors being dispersed or settled down therein, each of the red phosphors emitting red light in response to excitation light emitted from the blue LED chip; and
a silicone resin which is transparent and is provided so as to cover the red phosphor mixed resin.

2. The plant cultivation LED light source as set forth in claim 1, wherein the substrate is made of ceramic or a film-like base material.

3. The plant cultivation LED light source as set forth in claim 1 or 2, wherein each of the red phosphor mixed resin and the silicone resin has a dome shape.

4. The plant cultivation LED light source as set forth in claim 1, 2, or 3, wherein:
the blue LED chip emits light having a light emission peak at a wavelength in a range of 400 nm to 480 nm; and
each of the red phosphors emits light having a light emission peak at a wavelength in a range of 620 nm to 700 nm.

5. The plant cultivation LED light source as set forth in any one of claims 1 through 4, wherein:
a plurality of LED packages are provided on the substrate, each of the plurality of LED packages including the blue LED chip, the red phosphor mixed resin, and the silicone resin, the red phosphor mixed resin and the silicone resin being provided so as to cover the blue LED chip, and
as the plurality of LED packages, LED packages having different light amount ratios of blue region emission light to red region emission light are provided in combination.
